# FASCICULE DE BREVET EUROPEEN

(11) **EP 0 346 168 B1**
(45) Date de publication et mention de la délivrance du brevet: **15.12.1993**
(21) Numéro de dépôt: 89401287.1
(22) Date de dépôt: 09.05.1989
(51) Int. Cl.: H05H 1/46, H01J 37/32

(54) **Réacteur à plasma**
Plasmareaktor
Plasma reactor

(30) Priorité: 09.05.1988 FR 8806233
(43) Date de publication de la demande: 13.12.1989
(73) Titulaire: CENTRE NATIONAL DE LA RECHERCHE SCIENTIFIQUE (CNRS), 75700 Paris Cedex 07 (FR)
(72) Inventeur: Leprince, Philippe, F - 91190 - Gif-Sur-Yvette (FR); Chollet, Patrick, F - 91940 - Les Ulis (FR); Saada, Serge, F - 94270 - Kremlin Bicetre (FR)
(74) Mandataire: Plaçais, Jean-Yves

(56) Documents cités:
- EP-A- 0 046 945
- EP-A- 0 180 020
- EP-A- 0 183 561

## Description

L'invention est relative aux réacteurs à plasma. Elle trouve une application dans le traitement de surface d'échantillons, notamment en micro-électronique.

On connaît déjà des réacteurs à plasma comprenant une enceinte, mise sous vide, susceptible de recevoir un flux gazeux choisi, un générateur micro-ondes, et des moyens de guide d'ondes, pour amener les micro-ondes dans l'enceinte (EP-A-0 046 945).

Pour rendre homogène le plasma en vue d'obtenir un meilleur traitement de surface d'échantillons par exemple, il est prévu le plus souvent d'appliquer dans l'enceinte un champ magnétique de diffusion.

Or, l'application d'un tel champ magnétique de diffusion a l'inconvénient de consommer une grande quantité d'énergie, parfois supérieure à celle employée pour produire le plasma.

Il en résulte une limitation des dimensions du réacteur et par conséquent des dimensions du plasma obtenu, ce qui empêche le traitement d'échantillons de grands diamètres.

L'invention a pour but d'apporter une solution à ce problème.

Plus particulièrement, elle vise à améliorer la souplesse d'utilisation du réacteur à plasma et sa versatilité d'emploi.

L'invention porte sur un réacteur à plasma, comprenant : une enceinte, des moyens pour amener un flux gazeux de traitement choisi, un générateur micro-ondes, et des moyens de guide d'ondes pour amener les micro-ondes à l'enceinte, selon un couplage non résonant dans lequel l'enceinte ne dissipe pas sous forme de rayonnement électromagnétique l'énergie hyperfréquence qui lui est communiquée en présence du flux gazeux de traitement choisi dans l'enceinte pour l'obtention de plasma.

Selon une définition générale de l'invention, la partie terminale des moyens de guide d'ondes est progressivement amincie dans une première direction et élargie dans une seconde direction perpendiculaire à la première, jusqu'à atteindre une section droite rectangulaire plate entourant complètement ladite enceinte, tout en conservant le couplage non résonant avec ladite enceinte.

Selon un aspect de l'invention, il est prévu un court-circuit hyperfréquence du genre piston, logé à l'intérieur de la partie terminale des moyens de guide d'ondes et disposé du côté diamétralement opposé par rapport à l'amenée des micro-ondes, ledit piston étant ajusté pour définir un champ électrique hyperfréquence désiré dans l'enceinte.

Avantageusement, dans le cadre d'une application industrielle du réacteur à plasma selon l'invention, le court-circuit hyperfréquence est fixe.

De préférence, dans le cadre d'une application expérimentale du réacteur à plasma selon l'invention, le court-circuit hyperfréquence est mobile.

Selon un mode de réalisation préféré de l'invention, l'enceinte comprend un organe tubulaire interne mis sous vide et concentrique à l'enceinte, la paroi dudit organe tubulaire étant constituée d'un matériau possédant de faibles pertes diélectriques, comme le quartz.

Selon une autre caractéristique de l'invention, il est prévu à l'intérieur de l'enceinte, un court-circuit hyperfréquence supplémentaire, couplé à l'organe tubulaire et possédant des première et seconde plaques annulaires entourant ledit organe tubulaire, les plaques annulaires étant espacées l'une de l'autre d'une distance pré-définie et réglable en vue de confiner le plasma dans la portion de l'organe tubulaire comprise entre lesdites plaques annulaires.

Dans le cadre d'une application industrielle du réacteur à plasma, le court-circuit hyperfréquence supplémentaire est fixe.

Dans le cadre d'une application expérimentale du réacteur à plasma selon l'invention, le court-circuit hyperfréquence supplémentaire est mobile.

Selon un autre aspect de l'invention, le guide d'ondes comporte en sa partie intermédiaire, des moyens d'accord, tels qu'une pluralité de vis réglables pénétrantes.

En variante, le guide d'ondes comporte en sa partie terminale amincie dans un sens et élargie dans l'autre, des moyens d'accord, tels qu'une pluralité de vis réglables pénétrantes.

Dans le cadre d'un réacteur à plasma destiné au traitement de surface d'un échantillon, l'échantillon repose sur un porte-échantillons placé à l'intérieur de l'organe tubulaire et dans la portion de l'organe tubulaire comprise entre les plaques annulaires du court-circuit hyperfréquence supplémentaire.

Selon un autre mode de réalisation préféré de l'invention, le porte-échantillons est placé dans l'organe tubulaire et hors de la portion comprise entre les plaques annulaires du court-circuit hyperfréquence supplémentaire.

Dans le cadre d'une application de gravure de substrats, et/ou délaquage, le réacteur à plasma comprend en outre des moyens générateurs pour engendrer un champ électromagnétique entre les moyens d'amener du flux gazeux et le porte-échantillons, en vue de polariser l'échantillon.

Avantageusement, le réacteur à plasma comprend en outre des moyens de chauffage pour chauffer l'échantillon.

Selon une autre caractéristique de l'invention, il est prévu un sas d'introduction d'échantillons pour permettre le placement d'un échantillon sur le porte-échantillons.

D'autres caractéristiques et avantages de l'invention apparaîtront à l'examen de la description détaillée ci-après, ainsi que des dessins annexés, sur lesquels :
- la figure 1 est une vue schématique en coupe transversale du réacteur à plasma selon l'invention;
- la figure 2 est une vue de dessus du réacteur à plasma de la figure 1;
- la figure 3 est une vue générale schématique des moyens essentiels et constitutifs du réacteur à plasma selon l'invention; et
- la figure 4 est une vue en coupe transversale du réacteur à plasma selon l'invention équipé des moyens de polarisation de l'échantillon.

Les dessins annexés comportent de nombreux éléments de caractère certain qu'ils peuvent seuls apporter. Ils font donc partie intégrante de la description, pour servir à faire comprendre l'invention, aussi bien qu'à la définir.

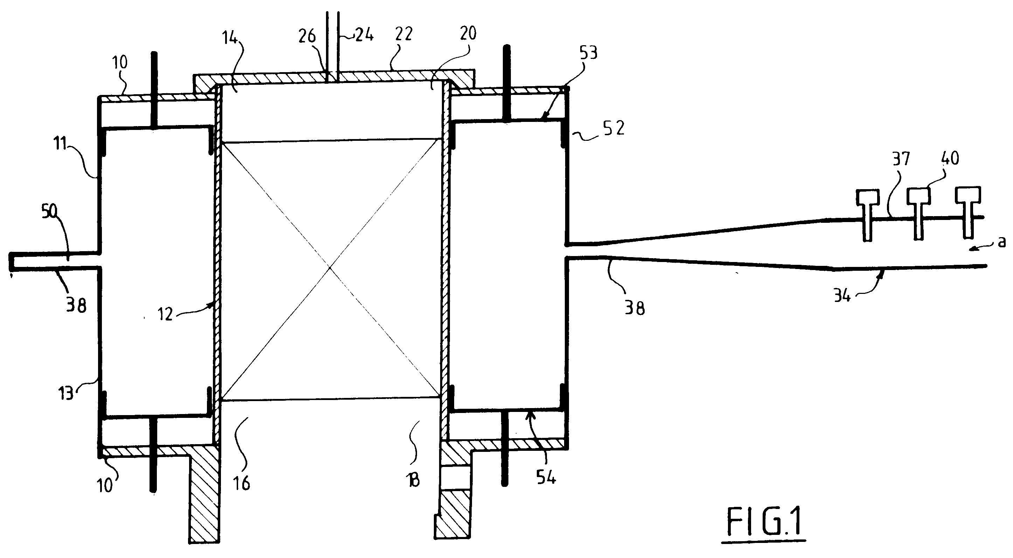

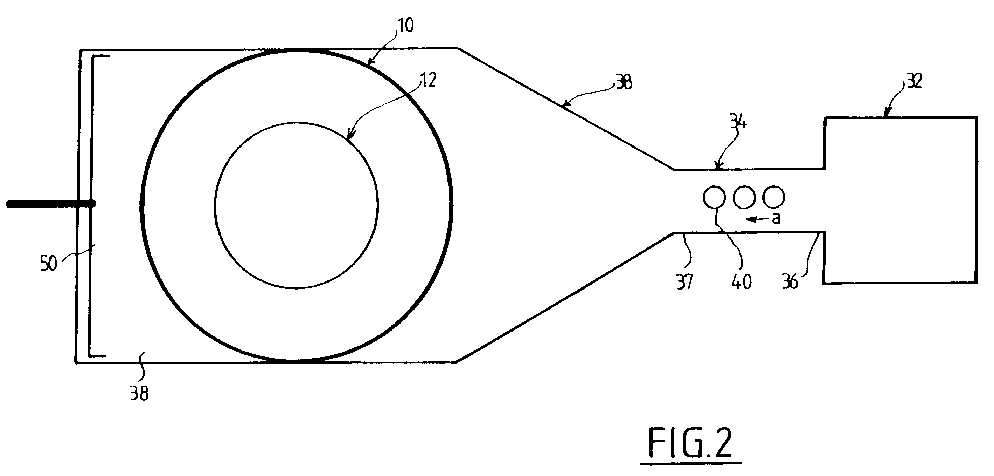

Un réacteur à plasma (figures 1 et 2) comprend une enceinte métallique 10, par exemple du cuivre, ayant une enveloppe de forme générale cylindrique.

L'enceinte 10 comprend un tube cylindrique interne 12, concentrique à l'enceinte 10 et dont la paroi est constituée d'un matériau à faibles pertes diélectriques, comme le quartz.

Le tube 12 possède à chacune de ses extrémités 14 et 16 un orifice circulaire.

La partie inférieure de l'enceinte 10 est munie d'une ouverture circulaire 18, concentrique à l'enceinte 10, de diamètre sensiblement égal à celui de l'orifice 16 du tube 12. Les ouvertures circulaires 16 et 18 sont superposées de telle manière que le tube 12 communique avec l'extérieur de l'enceinte 10.

La partie supérieure de l'enceinte 10 est également munie d'une ouverture circulaire 20, concentrique à l'enceinte 10, de diamètre sensiblement égal à celui de l'orifice 14 du tube 12. L'ouverture circulaire 20 est bouchée complètement par un couvercle circulaire métallique 22, de l'aluminium par exemple. Le couvercle 22 est percé en son centre d'un orifice permettant le passage d'un tube 24 dont l'extrémité 26 débouche dans le tube 12.

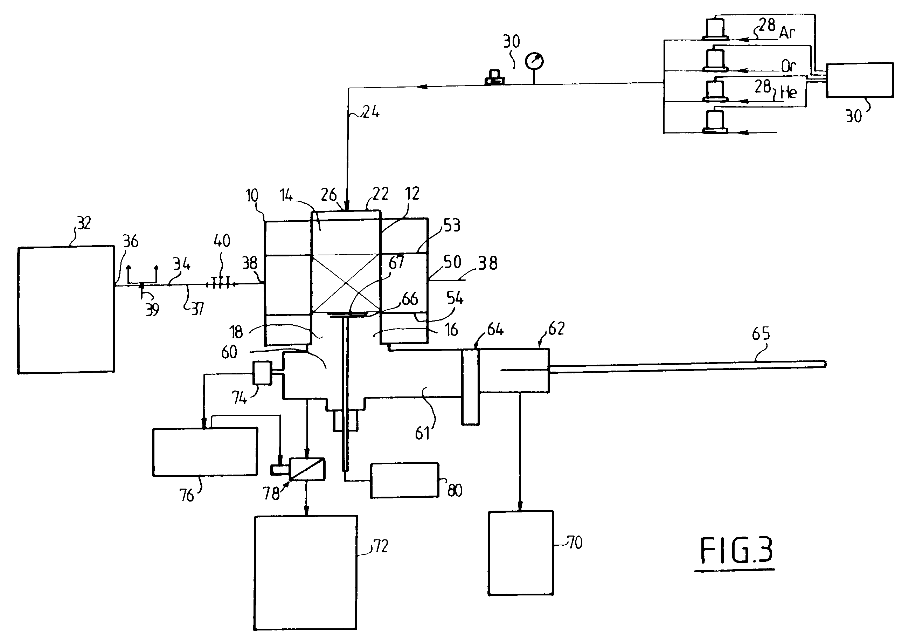

On se réfère maintenant à la figure 3. Un flux gazeux choisi circule dans le tube 24. Le tube 24 peut être raccordé par des moyens conventionnels à des bouteilles 28 contenant des gaz tels que de l'argon, oxygène, hélium, etc...

Des moyens de contrôle 30 tels que des débitmètres et des contrôleurs de débits, permettent de contrôler le débit du flux gazeux dans le tube 24 ainsi que d'obtenir un mélange de gaz choisi.

On se réfère à nouveau aux figures 1 et 2. Le réacteur à plasma comprend encore un générateur micro-ondes 32 propre à opérer à une fréquence de l'ordre de 2,45 gigahertz et à une puissance de 1,2 kilowatt.

Des moyens de guide d'ondes 34 amènent les micro-ondes à l'enceinte 10 selon un couplage non-résonant dans lequel l'enceinte 10 ne dissipe pas sous forme de rayonnement électromagnétique, l'énergie hyperfréquence qui lui est communiquée en présence de gaz dans ladite enceinte 10. Les parties initiales 36 et intermédiaire 37 des moyens de guide d'ondes ont une section rectangulaire. L'énergie électromagnétique se propage dans ce guide dans la direction longitudinale du guide 34 (flèche a), le champ électrique E étant orienté transversalement à la direction a.

Il est prévu en la partie initiale 36 du guide d'ondes 34, un coupleur bidirectionnel 39. En sa partie intermédiaire 37, les moyens de guide d'ondes comportent une pluralité de vis de réglage pénétrantes 40 (par exemple au nombre de 3) permettant d'adapter l'impédance du réacteur en vue d'obtenir un bon rendement de la transmission hyperfréquence, en direction de l'enceinte 10.

En variante, les vis 40 peuvent être disposées en la partie terminale 38 des moyens de guide d'ondes que l'on décrira ci-après.

Selon la principale caractéristique de l'invention, la partie terminale 38 des moyens de guide d'ondes est progressivement amincie dans un sens (direction verticale) et élargie dans l'autre (direction horizontale), jusqu'à atteindre une section droite rectangulaire plate entourant complètement l'enceinte 10.

L'enceinte 10 en sa partie intermédiaire est subdivisée en deux demi-enceintes 11 et 13 séparées l'une de l'autre d'un espace ("gap" ou entrefer) de section droite rectangulaire sensiblement égale à celle de la partie terminale 38 des moyens de guide d'ondes de manière à être complètement entourée par ladite partie terminale 38 des guides d'ondes. Ainsi la partie terminale 38 des guides d'ondes entoure complètement l'enceinte 10 au niveau de la séparation des deux demi-enceintes 11 et 13 de manière à amener les micro-ondes au tube 12.

La section droite rectangulaire de la partie terminale 38 des guides d'ondes est plus grande que celle de l'espace séparant les deux demi-enceintes 11 et 13. Il se trouve ainsi ménagé un espace ("gap" ou entrefer) qui permet le couplage non-résonant du guide d'ondes à l'enceinte 10.

La forme géométrique originale de la partie terminale du guide d'ondes, à savoir amincissement dans un sens et élargissement dans l'autre, permet de répartir l'énergie électromagnétique de façon uniforme sur toute la section de l'enceinte 10. Il en résulte une zone d'excitation beaucoup plus grande que celle proposée par les guides d'ondes cylindrique ou rectangulaire classiques. D'autre part, la partie terminale 38 est pincée en son extrémité afin d'accroître la directivité de l'onde électromagnétique incidente.

Théoriquement, une telle partie terminale des guides d'ondes devrait produire des ondes de mode supérieur dans l'enceinte, susceptibles de dissiper l'énergie hyperfréquence communiquée à l'enceinte via le guide d'ondes.

Or, de façon surprenante, les Demandeurs ont constaté qu'un tel réacteur à plasma comprenant un guide d'ondes ayant une section rectangulaire plate entourant complètement l'enceinte, constitue une structure absorbante dans laquelle les ondes de mode supérieur ne se créent pas.

Du côté diamétralement opposé par rapport à l'amenée des micro-ondes 34, il est prévu un couplage non-résonant avec l'enceinte, également entouré complètement par la partie terminale des moyens de guide d'ondes 38.

Le couplage non-résonant est un court-circuit 50 du genre piston. Le piston 50 comprend une section droite rectangulaire plate sensiblement égale à celle de la partie terminale des moyens de guide d'ondes 38.

Le couplage est non-résonant car en présence de plasma dans le tube 12, le couplage ne dissipe pas sous forme de rayonnement électromagnétique, l'énergie hyperfréquence qui lui est communiquée.

La position du piston 50 est ajustée pour définir un champ électrique hyperfréquence désiré dans l'enceinte 10. On remarquera que le court-circuit piston 50 présente les mêmes caractéristiques de répartition de l'onde électromagnétique que la partie terminale des guides d'ondes 38, ce qui permet d'assurer une symétrie dans la propagation des ondes. Le réglage de la position du piston 50 permet d'obtenir des couplages meilleurs que 90%. Le guide d'ondes rectangulaire 34 muni de ses vis d'adaptation 40 permet quant à lui d'affiner le couplage à mieux que 95%.

Dans le cadre d'une application industrielle, la position du piston 50 est fixe tandis que dans le cadre d'une application expérimentale, le piston 50 est mobile.

A l'intérieur de l'enceinte 10, il est prévu un second court-circuit hyperfréquence 52 couplé au tube 12. Ce second court-circuit 52 comprend deux plaques annulaires 53 et 54 de type également piston.

Le plasma prend naissance dans le tube 12 et il peut être plus ou moins confiné grâce aux deux plaques annulaires 53 et 54 dont la hauteur est réglable.

Les pistons 53 et 54 sont ainsi espacés l'un de l'autre d'une distance pré-définie et réglable en vue de confiner le plasma dans la portion du tube 12 comprise entre les deux pistons 53 et 54.

Dans le cadre d'une application industrielle, les pistons 53 et 54 sont fixes tandis que dans le cadre d'une application expérimentale, les pistons 53 et 54 sont mobiles.

On se réfère à nouveau à la figure 3.

L'ouverture circulaire 18 de la partie inférieure de l'enceinte 10 communique avec l'extérieur par l'intermédiaire d'une autre ouverture cylindrique 60 de diamètre sensiblement égal à celui de l'ouverture 18 et réalisée dans le couvercle d'une boîte 61 en métal, de l'aluminium par exemple, sur laquelle repose l'enceinte 10. Les ouvertures 16, 18 et 60 sont superposées de manière à ce que le tube 12 communique avec l'intérieur de la boîte 61.

La boîte 61 est de forme générale rectangulaire possédant sur l'une de ses faces latérales, un sas 62 couplé à une vanne 64 du genre tiroir pour permettre l'introduction d'échantillons dans le tube 12 où se produit le plasma.

Un échantillon 67 destiné à être traité par le plasma est acheminé de l'extérieur de la boîte 61 vers un porte-échantillons 66 par l'intermédiaire d'une canne de transfert 65. Le porte-échantillons 66 est placé à l'intérieur de la boîte 61 et concentriquement au tube 12. Ce porte-échantillons 66 est mobile en translation verticale, ce qui lui permet de porter l'échantillon 67 hors ou dans le plasma se produisant dans le tube 12. Dans le cas de traitement de surfaces d'échantillons comprenant des matériaux fragiles tels que des polymères, il est préférable que l'échantillon soit porté hors du plasma, à proximité de celui-ci.

Le tube 12 et la boîte 61 sont mis sous vide par des moyens de pompage primaire 70 établissant un vide grossier et par des moyens de pompage secondaire établissant un vide plus poussé. Les moyens de pompage secondaire 72 sont des pompes de type ROOTS ayant un débit de l'ordre de 250 mètres cubes par heure.

Un jauge de pression 74 complète le dispositif de mise sous vide. Cette jauge 74 possède une entrée reliée à la boîte 61 et une sortie branchée à un contrôleur de pression 76. En réponse à la pression mesurée par la jauge 74, le contrôleur de pression 76 actionne un moteur (non représenté) commandant l'ouverture/fermeture d'une vanne 78 reliée aux moyens de pompage secondaires 72 en vue de contrôler leur débit.

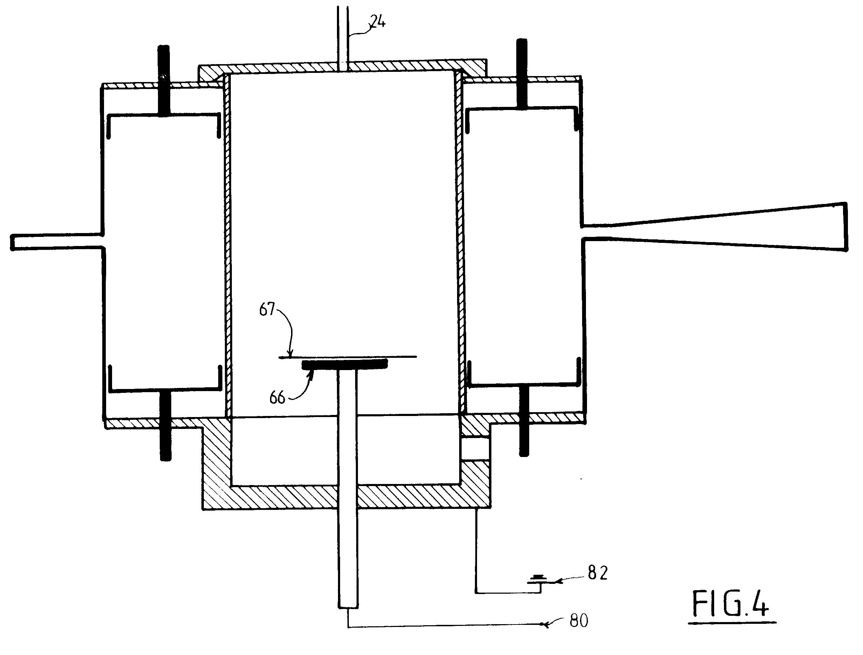

On se réfère maintenant à la figure 4. Pour des traitements de surfaces particuliers, notamment pour la gravure d'une couche d'oxyde de silicium déposée sur un substrat en micro-électronique, il est établi qu'un plasma micro-ondes seul ne permet pas d'obtenir une gravure rapide dudit oxyde de silicium.

Dans ce cas, le réacteur à plasma selon l'invention comprend en outre des moyens générateurs 80 propres à superposer un champ électromagnétique radiofréquence entre les moyens d'amenée du flux gazeux 24 et le porte-échantillons 66 en vue d'augmenter la vitesse de gravure.

Les moyens générateurs 80 délivrent par exemple une tension alternative d'une fréquence de l'ordre de 13 mégahertz. Cette tension alternative est par exemple appliquée au porte-échantillons 66 tandis que l'enceinte 10 est mise à la masse.

Les Demandeurs ont obtenu des vitesses de gravure de l'ordre de quelques décimicrons (milliers d'Angström) par minute avec une gravure de bonne homogénéité. Ce résultat s'explique par le fait que le plasma micro-ondes est très riche en ions positifs. En effet, ces ions positifs bombardent l'échantillon 67 polarisé négativement en présence du champ électromagnétique engendré par l'application de la tension alternative sur le porte-échantillons 66.

Pour des traitements de surface d'échantillons tels que le délaquage de résine, les Demandeurs ont obtenu une attaque homogène de la résine de l'ordre de plusieurs microns par minute. Les meilleurs résultats concernant l'homogénéité d'attaque l'étaient par un substrat placé hors du plasma. Le gaz utilisé pour le délaquage de la résine était de l'oxygène pur ou un mélange à base d'oxygène.

Parfois, il y a lieu également de chauffer l'échantillon. Dans ce cas, le réacteur à plasma comprend en outre des moyens de chauffage propres à chauffer l'échantillon. Avantageusement, le champ électromagnétique engendré par l'application de la tension alternative permet de chauffer l'échantillon 67.

La mise en oeuvre du réacteur à plasma s'effectue comme suit :
- on ajuste d'abord le couplage entre le piston 50 et le guide d'ondes 34 comme précédemment décrit;
- on ajuste ensuite le court-circuit supplémentaire 52 pour confiner le plasma entre les deux plaques annulaires 53 et 54 de ce court-circuit 52 avec le tube 12.

Les essais ont ensuite été conduits avec des pressions de remplissage du réacteur variables entre 1 Pa et 10³ Pa (10 milli-Torr et 10⁴ milli-Torr), pour des configurations gazeuses suivantes : oxygène pur, argon pur, et mélange argon-oxygène dans lequel le pourcentage d'argon en volume était de 66%. La puissance micro-ondes appliquée était de 800 watts. Le réglage du court-circuit 50 et des vis 40 était effectué pour donner une puissance réfléchie minimale aux environs de (10 Pa) (10² milli-Torr).

On a pu alors observer pour l'oxygène pur que le réacteur à plasma était d'une stabilité remarquable avec un rapport puissance réfléchie/puissance totale appelé encore TOS, pour Taux d'Ondes Stationnaires, qui n'excédait pas 2% entre 1 Pa et 10² Pa (10 milli-Torr et 1 Torr). Au-delà de 10² Pa (d'un Torr), ce rapport TOS augmentait très rapidement jusqu'à l'extinction du plasma.

En argon pur, le TOS restait bas (inférieur à 7%) mais cependant bien supérieur qu'en oxygène pur.

En mélange argon-oxygène, l'étendue de fonctionnement pression s'étendait au-delà de 10² Pa (d'un Torr) avec des TOS de l'ordre de quelques %. On retrouvait avec ce mélange argon-oxygène d'une part la large étendue de fonctionnement en argon et d'autre part un plasma qui permettait d'avoir une production d'oxygène réactif à haute pression.

D'autres essais ont été conduits avec les conditions expérimentales suivantes. La puissance micro-ondes appliquée était rendue variable entre 200 et 1200 watts.

On a pu alors observer que le fonctionnement du réacteur à plasma restait stable avec des TOS inférieurs à 7% et avec des régions d'adaptation quasi parfaites. D'autre part, et à l'image des résultats précédents, la stabilité du réacteur est meilleure en oxygène pur qu'en argon ou en mélange argon-oxygène.

Ces essais montrent que les réacteurs à plasma selon l'invention présentent l'avantage d'une grande dynamique de fonctionnement, tant en pression qu'en puissance, avec des TOS faibles voire très faibles.

De plus, un plasma très stable peut être obtenu avec des variations relatives en pression et/ou en puissance importante. Les conditions d'obtention du plasma sont facilement reproductibles. D'autres gaz tels que l'éthylène, l'azote, le chlorure de silicium peuvent être utilisés pour le flux gazeux tout en conservant les mêmes caractéristiques de fonctionnement du réacteur.

Les Demandeurs ont également remarqué que la distribution du champ électromagnétique présente un maximum au voisinage de la paroi du tube 12 et un minimum au centre dudit tube. Dans ces conditions, il semble que les ondes hyperfréquences produites dans le gaz soient essentiellement des ondes de surface. Le plasma qui est donc homogène dans la portion comprise entre les plaques annulaires 53 et 54 du court-circuit supplémentaire 52 est alors le siège d'ondes hyperfréquences stationnaires de très forte intensité.

Les Demandeurs ont également remarqué que la fréquence d'excitation c'est-à-dire la fréquence du générateur micro-ondes influe sur la densité électronique et le volume du plasma.

Ils ont ainsi remarqué que lorsque l'on diminue la fréquence d'excitation, on diminue corollairement la densité électronique, mais dans le même temps, il est possible d'augmenter le volume du plasma. Ainsi pour les applications nécessitant par exemple un plasma de très grand volume et une faible densité électronique, il est nécessaire de baisser la fréquence d'excitation. Et vice versa.

Les différents essais ont été conduits avec un réacteur à plasma dont les dimensions sont les suivantes.

Les dimensions de l'enceinte 10 étaient : diamètre environ 400 millimètres, hauteur 300 millimètres.

Les dimensions du tube 12 étaient : diamètre environ 195 millimètres, hauteur environ 300 millimètres.

Les dimensions du guide d'ondes en sa partie intermédiaire 37 étaient en section transversale : 43x86 millimètres.

Les dimensions du court-circuit 50 étaient en sa section transversale : environ 400x10 millimètres.

Les dimensions du guide d'ondes en sa partie terminale en sa section transversale étaient de : 400x10 millimètres environ.

Les avantages du réacteur à plasma selon l'invention sont les suivants :
- absence d'électrodes;
- absence de champ magnétique de diffusion grand consommateur d'énergie;
- densité électronique d'espèces élevée (densité électronique avec argon de l'ordre de 10¹² à 10¹³ par centimètre cube);
- grande dynamique de fonctionnement en pression (de quelques 10⁻¹ Pascals à quelques 10² Pascals) (de quelques 10⁻³ Torr à quelques Torr);
- stabilité et reproductibilité des conditions de fonctionnement;
- plasma de grande section et de grand volume;
- ajustement du volume de plasma par confinement du champ électromagnétique (réglage du court-circuit 52);
- ajustement du volume de plasma par la valeur de la puissance incidente (réglage de la puissance du générateur 32);
- homogénéité de répartition des espèces;
- très bon couplage non-résonant en énergie hyperfréquence;
- stabilité du couplage non-résonant pour des mélanges gazeux divers.

## Revendications

1. Réacteur à plasma comprenant :
- une enceinte (10);
- des moyens (24) pour amener un flux gazeux de traitement choisi à l'enceinte;
- un générateur micro-ondes (32);
- des moyens de guide d'ondes (34) pour amener les micro-ondes à l'enceinte (10),
l'enceinte et les moyens de guide d'ondes étant couplés l'un à l'autre selon un couplage non-résonant dans lequel l'enceinte ne dissipe pas sous forme de rayonnement électromagnétique l'énérgie hyperfréquence qui lui est communiquée en présence du flux gazeux de traitement choisi dans ladite enceinte pour l'obtention de plasma,
caractérisé en ce que
la partie terminale des moyens de guide d'ondes (38) est progressivement amincie dans une première direction et élargie dans une seconde direction perpendiculaire à la première, jusqu'à atteindre une section droite rectangulaire plate entourant complétement ladite enceinte (10) tout en conservant le couplage non-résonant avec l'enceinte.

2. Réacteur à plasma selon la revendication 1, caractérisé en ce qu'il comprend en outre un court-circuit du genre piston, logé à l'intérieur de la partie terminale des moyens de guide d'ondes (38) et disposé du côté diamétralement opposé par rapport à l'amenée des micro-ondes, ledit piston (50) étant ajusté pour définir un champ électrique hyperfréquence désiré dans l'enceinte.

3. Réacteur à plasma selon la revendication 2, caractérisé en ce que le court-circuit (50) est fixe.

4. Réacteur à plasma selon la revendication 2, caractérisé en ce que le court-circuit (50) est mobile.

5. Réacteur à plasma selon l'une quelconque des revendications précédentes, caractérisé en ce que l'enceinte (10) comprend un organe tubulaire interne (12), mis sous vide, et concentrique à l'enceinte (10), la paroi dudit organe tubulaire (12) étant constituée d'un matériau possédant de faibles pertes diélectriques, comme le quartz.

6. Réacteur à plasma selon l'une quelconque des précédentes revendications, caractérisé en ce qu'il est prévu à l'intérieur de l'enceint (10), un court-circuit supplémentaire (52) couplé à l'organe tubulaire (12) et possédant des première et seconde plaques annulaires (53,54) entourant l'organe tubulaire (12), lesdites plaques annulaires (53,54) étant espacées l'une de l'autre d'une distance pré-définie et réglable en vue de confiner le plasma dans la portion de l'organe tubulaire (12) comprise entre lesdites plaques annulaires (53,54).

7. Réacteur à plasma selon la revendication 6, caractérisé en ce que le court-circuit supplémentaire (52) est fixe.

8. Réacteur à plasma selon la revendication 6, caractérisé en ce que le court-circuit supplémentaire (52) est mobile.

9. Réacteur à plasma selon l'une quelconque des revendications précédentes, caractérisé en ce que le guide d'ondes comporte en sa partie intermédiaire (37), des moyens d'accord, tels qu'une pluralité de vis réglables pénétrantes (40).

10. Réacteur selon l'une quelconque des revendications 1 à 8, caractérisé en ce que le guide d'ondes comporte en sa partie terminale amincie dans un sens et élargie dans l'autre, des moyens d'accord, tels qu'une pluralité de vis réglables pénétrantes (40).

11. Réacteur à plasma destiné au traitement de surface d'un échantillon selon l'une quelconque des précédentes revendications, caractérisé en ce que l'échantillon (67) repose sur un porte-échantillons (66) placé à l'intérieur de l'organe tubulaire (12) dans la portion comprise entre les deux plaques annulaires (53,54) dans laquelle se forme le plasma.

12. Réacteur à plasma destiné au traitement de surface d'un échantillon selon l'une quelconque des revendications 1 à 10, caractérisé en ce que l'échantillon (67) repose sur un porte-échantillons (66) placé dans l'organe tubulaire (12) et hors de la portion comprise entre les deux plaques annulaires (53 et 54) dans laquelle se forme le plasma.

13. Réacteur selon la revendication 11 ou la revendication 12, caractérisé en ce qu'il comprend en outre des moyens générateurs (80) pour engendrer un champ électromagnétique radiofréquence entre les moyens d'amenée du flux gazeux (24) et le porte-échantillons (66) en vue de polariser l'échantillon (67).

14. Réacteur selon l'une des revendications 11 à 13, caractérisé en ce qu'il comprend en outre des moyens de chauffage pour chauffer l'échantillon.

15. Réacteur à plasma selon l'une des revendications 11 à 14, caractérisé en ce qu'il est prévu un sas d'introduction d'échantillons pour permettre le placement d'un échantillon (67) sur le porte-échantillons (66).

## Claims

1. Plasma reactor comprising:
- a chamber (10);
- means (24) for bringing a flow of gas for the chosen treatment to the chamber;
- a microwave generator (32);
- waveguide means (34) for bringing the microwaves to the chamber (10),
the chamber and waveguide means being coupled to each other in a non-resonant coupling in which the chamber does not dissipate, in the form of electromagnetic radiation, the UHF energy communicated to it in the presence of the flow of gas for the chosen treatment in the said chamber for obtaining plasma,
characterised in that
the end part of the waveguide means (38) becomes progressively narrower in a first direction and broader in a second direction at right angles to the first, until it reaches a flat rectangular cross section completely surrounding the said chamber (10) whilst retaining the non-resonant coupling with the chamber.

2. Plasma reactor according to Claim 1, characterised in that it also comprises a short circuit of the piston type, housed inside the end part of the waveguide means (38) and disposed on the side which is diametrically opposite with respect to the waveguide entry, the said piston (50) being adjusted so as to define a desired UHF electrical field in the chamber.

3. Plasma reactor according to Claim 2, characterized in that the short circuit (50) is fixed.

4. Plasma reactor according to Claim 2, characterized in that the short circuit (50) is movable.

5. Plasma reactor according to any one of the preceding claims, characterized in that the chamber (10) comprises an internal tubular member (12) put under vacuum and concentric with the chamber (10), the wall of the said tubular member (12) being formed from a material having low dielectric losses, such as quartz.

6. Plasma reactor according to any one of the preceding claims, characterized in that, inside the chamber (10), an additional short circuit (52) is provided, coupled to the tubular member (12) and having first and second annular plates (53, 54) surrounding the tubular member (12), the said annular plates (53, 54) being spaced apart from each other by a predefined distance and adjustable for the purpose of confining the plasma in the portion of the tubular member (12) lying between the said annular plates (53, 54).

7. Plasma reactor according to Claim 6, characterized in that the additional short circuit (52) is fixed.

8. Plasma reactor according to Claim 6, characterised in that the additional short circuit (52) is movable.

9. Plasma reactor according to any one of the preceding claims, characterised in that the waveguide has, in its intermediate part (37), tuning means such as a plurality of adjustable screws (40) entering therein.

10. Reactor according to any one of Claims 1 to 8, characterized in that the waveguide has, in its end part which is narrow in one direction and broad in the other, tuning means such as a plurality of adjustable screws (40) entering therein.

11. Plasma reactor intended for the surface treatment of a sample, according to any one of the preceding claims, characterised in that the sample (67) rests on a sample support (66) positioned inside the tubular member (12) in the portion lying between the two annular plates (53, 54) in which the plasma is formed.

12. Plasma reactor intended for the surface treatment of a sample, according to any one of Claims 1 to 10, characterized in that the sample (67) rests on a sample support (66) positioned in the tubular member (12) and outside the portion lying between the two annular plates (53 and 54) in which the plasma is formed.

13. Reactor according to Claim 11 or Claim 12, characterised in that it also comprises generating means (80) for generating a radiofrequency electromagnetic field between the means for bringing in the flow of gas (24) and the sample support (66) for the purpose of biasing the sample (67).

14. Reactor according to one of Claims 11 to 13, characterized in that it also comprises heating means for heating the sample.

15. Plasma reactor according to one of Claims 11 to 14, characterised in that an airlock for inserting samples is provided so as to enable a sample (67) to be placed on the sample support (66).

## Patentansprüche

1. Plasmareaktor mit
einem Gehäuse (10),
einer Einrichtung (24) zum Zuführen einer gewünschten Behandlungsgasströmung in das Gehäuse,
einem Mikrowellen-Erzeuger (32) und
einer Wellen-Führungsvorrichtung (34), die die Mikrowellen in das Gehäuse (10) leitet,
wobei das Gehäuse und die Wellen-Führungsvorrichtung über eine nicht-resonante Kopplung miteinander gekoppelt sind, so daß das Gehäuse keine Hochfrequenzenergie in Form elektromagnetischer Strahlung abstrahlt, die bei Vorhandensein der gewünschten Behandlungsgasströmung zur Plasmaerzeugung in das Gehäuse eingestrahlt wird,
dadurch gekennzeichnet, daß
der Ausgangsabschnitt (38) der Wellen-Führungsvorrichtung sich in einer ersten Richtung fortlaufend verjüngt und in einer senkrecht zur ersten Richtung verlaufenden zweiten Richtung verbreitert, bis er einen flachen rechtwinkligen Querschnitt aufweist, der das Gehäuse (10) völlig umschließt und die nicht-resonante Kopplung mit dem Gehäuse erhält.

2. Plasmareaktor nach Anspruch 1, gekennzeichnet durch eine Kurzschlußvorrichtung in Form eines Kolbens, der sich im Inneren des Ausgangsabschnittes (38) der Wellen-Führungsvorrichtung und an der diametral entgegengesetzten Seite bezüglich der Mikrowellenführung angeordnet ist, wobei der Kolben (50) derart angepaßt ist, daß er ein im Gehäuse gewünschtes elektrisches Hochfrequenzfeld bestimmt.

3. Plasmareaktor nach Anspruch 2, dadurch gekennzeichnet, daß die Kurzschlußvorrichtung (50) ortsfest ist.

4. Plasmareaktor nach Anspruch 2, dadurch gekennzeichnet, daß die Kurzschlußvorrichtung (50) verlagerbar ist.

5. Plasmareaktor nach einem der vorangehenden Ansprüche, dadurch gekennzeichnet, daß das Gehäuse (10) ein konzentrisch zum Gehäuse (10) ausgerichtetes inneres, luftleeres Rohrelement (12) aufweist, dessen Wandung aus einem Material besteht, das nur schwache dielektrische Verluste aufweist, z.B. Quartz.

6. Plasmareaktor nach einem der vorangehenden Ansprüche, dadurch gekennzeichnet, daß er im Inneren des Gehäuses (10) angeordnet ist, daß eine weitere Kurzschlußvorrichtung (52) mit dem Rohrelement (12) gekoppelt ist und eine erste und eine zweite ring-förmige Platte (53, 54) aufweist, die das Rohrelement (12) umschließen, einen vorbestimmten Abstand zueinander aufweisen und im Hinblick auf das Einschließen des Plasmas in dem zwischen den ringförmigen Platten (53, 54) angeordneten Abschnitt des Rohrelementes verstellbar sind.

7. Plasmareaktor nach Anspruch 6, dadurch gekennzeichnet, daß die zusätzliche Kurzschlußvorrichtung (52) ortsfest ist.

8. Plasmareaktor nach Anspruch 6, dadurch gekennzeichnet, daß die Kurzschlußvorrichtung (52) verlagerbar ist.

9. Plasmareaktor nach einem der vorangehenden Ansprüche, dadurch gekennzeichnet, daß die Wellen-Führungsvorrichtung in ihrem Mittelabschnitt (37) Einstellvorrichtungen, wie eine Vielzahl von hineinragender Verstellschrauben (40), aufweist.

10. Plasmareaktor nach einem der Ansprüche 1 bis 8, dadurch gekennzeichnet, daß die Wellen-Führungsvorrichtung an ihrem sich einerseits verjüngenden und andererseits verbreiternden Ausgangsabschnitt Einstellvorrichtungen, wie eine Vielzahl von hineinragenden Verstellschrauben (40), aufweist.

11. Plasmareaktor zur Oberflächenbehandlung einer Probe nach einem der vorangehenden Ansprüche, dadurch gekennzeichnet, daß die Probe (67) auf einem Probenträger (66) aufliegt, welcher im Inneren des Rohrelementes (12) in dem Abschnitt zwischen den zwei ringförmigen Platten (53, 54) plaziert ist, in dem sich das Plasma bildet.

12. Plasmareaktor zur Oberflächenbehandlung einer Probe nach einem der Ansprüche 1 bis 10, dadurch gekennzeichnet, daß die Probe (67) auf einem Probenträger (66) aufliegt, der in dem Rohrelement (12) außerhalb ten (53, 54) plaziert ist, in dem sich das Plasma bildet.

13. Plasmareaktor nach Anspruch 11 oder 12, gekennzeichnet durch eine Generatoreinrichtung (80) zur Erzeugung eines elektromagnetischen Feldes im Radiowellenbereich zwischen der Zuführeinrichtung für die Gasströmung (24) und dem Probenträger (66), um die Probe (67) zu polarisieren.

14. Plasmareaktor nach einem der Ansprüche 11 bis 13, gekennzeichnet durch eine Heizvorrichtung zum Erwärmen der Probe.

15. Plasmareaktor nach einem der Ansprüche von 11 bis 14, gekennzeichnet durch eine Probeneinführschleuse, um eine Probe (67) auf dem Probenträger (66) plazieren zu können.
